# EUROPEAN PATENT SPECIFICATION

(11) **EP 3 031 789 B1**
(45) Date of publication and mention of the grant of the patent: **11.11.2020**
(21) Application number: 14835334.5
(22) Date of filing: 05.08.2014
(51) Int. Cl.: C04B 37/02, B23K 1/00, B23K 1/19, H01L 23/15, H01L 23/36, B23K 101/42, H05K 3/38, B23K 20/02, B23K 20/16, B23K 20/233, H01L 23/373

(54) **CIRCUIT SUBSTRATE AND SEMICONDUCTOR DEVICE**
SCHALTSUBSTRAT UND HALBLEITERBAUELEMENT
SUBSTRAT DE CIRCUIT ET DISPOSITIF SEMI-CONDUCTEUR

(30) Priority: 08.08.2013 JP 2013165043
(43) Date of publication of application: 15.06.2016
(73) Proprietor: Kabushiki Kaisha Toshiba, Minato-ku Tokyo 105-8001 (JP); Toshiba Materials Co., Ltd., Yokohama-shi, Kanagawa 235-8522 (JP)
(72) Inventor: KATO, Hiromasa, Tokyo 105-8001 (JP); HOSHINO, Masanori, Tokyo 105-8001 (JP)
(74) Representative: Henkel & Partner mbB
(86) International application number: PCT/JP2014/004081
(87) International publication number: WO 2015/019602

(56) References cited:
- JP-A- H05 347 469
- JP-A- H11 340 598
- JP-A- 2006 062 930
- JP-A- 2007 053 349
- JP-A- 2010 010 561

## Description

### FIELD

The embodiment generally relates to a circuit substrate and a semiconductor device.

### BACKGROUND

In recent years, a power module for controlling a large current/high voltage is used in an electric vehicle, an electric railcar, etc, in view of a high performance of an industrial equipment, a global environmental problem, and so on. Further, a semiconductor element such as a SiC element having a high output is being developed as a semiconductor element. Further, as the semiconductor element comes to have a high output, a circuit substrate having an excellent durability is demanded as a circuit substrate to mount a semiconductor element.

As the circuit substrate, there can be cited a ceramic substrate, an insulating circuit substrate having a metal circuit board, and so on. A reliability of the circuit substrate is evaluated by a TCT (Temperature Cycle Test). The TCT is an inspection method for investigating presence/absence of peeling of a metal circuit board, presence/absence of a crack of a ceramic substrate, or the like in a circuit substrate, after a processing of keeping a low temperature → keeping a room temperature → keeping a high temperature is repeated a certain number of cycles. The reliability evaluated by the TCT is also referred to as a TCT reliability.

As a circuit substrate having a high TCT reliability, there is known a circuit substrate which has a copper circuit board having an end surface of a broad base shape as a broad base of Mt. Fuji. The copper circuit board having the end surface of the broad base shape is formed by processing an end surface to be gently inclined, for example.

With regard to the copper circuit board having the end surface of the broad base shape, its thickness is required to be 0.8 mm or less. The end surface of the broad base shape is formed by etching a copper circuit board, for example. In order to etch the copper circuit board, it is necessary to use a chemical solution such as ferric chloride and cupric chloride. In a case where the above-described chemical solution is used, etching of the copper circuit board is difficult if the thickness of the copper circuit board is larger than 0.8 mm, though an etching technique enabling etching of a thick copper circuit board is being developed. In the above-described etching, there are problems not only that a cost is high but also that waste water disposal affects an environment.

When the semiconductor element becomes to have a higher output, it is necessary to apply a large current or a high voltage to the semiconductor element. Thus, it is desired to heighten a cooling effect of a circuit substrate by thickening the copper circuit board. However, when the thickness of the copper circuit board exceeds 0.7 mm, the TCT reliability is sometimes reduced due to a high thermal expansion coefficient of the copper circuit board.

Further, in the copper circuit board having the end surface of the broad base shape, it is difficult to mount a semiconductor element in an end portion. In order to secure a dimension between circuit patterns of the copper circuit board while securing a space to mount the semiconductor element, it is necessary to make the copper circuit board large considering the broad base shape. Consequently, a degree of freedom in circuit design is reduced.

### RELEVANT REFERENCES

### Patent Reference

Reference 1: WO 2011/034075 A1

JP 2010 010561 A discloses a power module substrate and a method of manufacturing the same. The power module substrate comprises a metal plate brazed and bonded onto a surface of a ceramic substrate. Onto a side face of the metal plate, the brazing filler metal is exposed in a range H of 1/8-1/6 of the plate thickness of the metal plate from the bonded surface between the metal plate and the ceramic substrate.

JP H05 347469 A discloses a ceramic circuit board having a ceramic board and a metal circuit board connected to the board through a brazing material layer. The layer is so provided as to cover part of a side face of the board.

JP H11 340598 A discloses a ceramic circuit board comprising metal plates connected to at least one main surface of a ceramic board via a brazing material layer to form a predetermined metal circuit pattern by etching the plate, wherein the layer is formed to externally overhand in the outward direction from a side face of the pattern.

JP 2006 062930 A discloses a joined body of a ceramic and a metal which is formed by joining a ceramic substrate and a metallic plate to each other with an activated brazing filler metal being formed by joining the metallic plate having a size smaller than that of a pattern of a metallized film in the plane view to the ceramic substrate through the metallized film formed on the ceramic substrate and the activated brazing filler metal formed on the metallized film.

### SUMMARY

An embodiment provides a circuit substrate which has a high TCT reliability even when a copper circuit board is thickened and which has a high degree of freedom in circuit design.

Accordingly, there is provided a circuit substrate as set out in independent claim 1, and a semiconductor device as set out in claim 12. Advantageous developments are defined in the dependent claims.

### BRIEF DESCRIPTION OF THE DRAWINGS

[Fig. 1] is a diagram showing an example of a circuit substrate.
[Fig. 2] is a diagram showing an example of the circuit substrate.
[Fig. 3] is a diagram showing an example of the circuit substrate.
[Fig. 4] is a diagram showing an example of the circuit substrate.
[Fig. 5] is a diagram showing an example of a semiconductor device.

### DETAILED DESCRIPTION

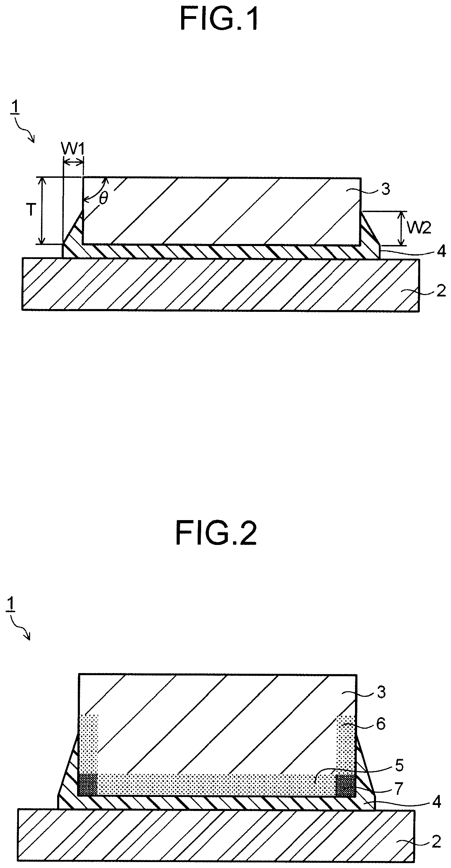

Fig. 1 is a diagram showing a configuration example of a circuit substrate. A circuit substrate 1 shown in Fig. 1 has a ceramic substrate 2, a copper circuit board 3, and a bonding layer 4.

The ceramic substrate 2 has a first surface and a second surface facing the first surface, for example. As the ceramic substrate 2, it is possible to use a silicon nitride substrate, an aluminum nitride substrate, an aluminum oxide substrate, or the like, for example.

As the silicon nitride substrate, it is possible to use a silicon nitride substrate having a heat conductivity of 70 W/m.K or more and having a bending strength (three-point bending strength) by a three-point bending test of 600 MPa or more, for example. The silicon nitride substrate has a high strength even in a case of having a heat conductivity of 70 W/m.K or more to 110 W/m.K or less, for example. Thus, it is possible to make a thickness be 0.1 mm or more to 1.0 mm or less, preferably be 0.1 mm or more to 0.4 mm or less. By thinning the ceramic substrate, the heat conductivity can be heightened. The three-point bending strength of the silicon nitride substrate is more preferable to be 650 MPa or more.

As the aluminum nitride substrate, it is possible to use an aluminum nitride substrate having a heat conductivity of 160 W/m.K or more and having a three-point bending strength of 300 MPa or more, for example. A strength of the aluminum nitride substrate is as low as 300 MPa or more to 550 MPa or less. Thus, a thickness of the aluminum nitride substrate is preferable to be 0.5 mm or more to 1.2 mm or less. Further, with regard to the aluminum nitride substrate, it is possible to make the heat conductivity be 160 W/m.K or more, and further, be 200 W/m.K or more.

As the aluminum oxide substrate, it is possible to use an aluminum oxide substrate having a heat conductivity of 20 W/m.K or more to 40 W/m.K or less and having a three-point bending strength of 400 MPa or more, for example. The aluminum oxide substrate is less expensive than the silicon nitride substrate and the aluminum nitride substrate.

The copper circuit board 3 is provided on one side surface (first surface) of the ceramic substrate 2. The copper circuit board 3 is bonded to the first surface of the ceramic substrate 2 while sandwiching the bonding layer 4.

The copper circuit board 3 has a semiconductor element mounting portion provided on a surface. On this occasion, the copper circuit board 3 is preferable to have an interior angle of an angle θ (also referred to as a sectional angle θ of an end portion) of 85° or more to 95° or less in a cross section.

As a result that the interior angle of the copper circuit board 3 is made to be almost right-angled in the cross section of the coper circuit board 3, it is possible to use the copper circuit board 3 end portion as the semiconductor element mounting portion. Further, it becomes easy to detect the copper circuit board 3 end portion by a position detector such as a CCD camera. In order to improve a detection accuracy of the copper circuit board 3 end portion, it is preferable to make the angle θ be 89° or more to 91° or less, and further, be 90°.

An area of the semiconductor element mounting portion is preferable to be 25 mm² or more. A degree of freedom in circuit design can be heightened by making the area of the semiconductor element mounting portion large. The area of the semiconductor element mounting portion is more preferable to be 1 cm² or more (100 mm² or more).

Here, the area of the semiconductor element mounting portion is a surface area of the copper circuit board 3 which is usable as a mounting region of a semiconductor element. For example, in the circuit substrate 1 shown in Fig. 1, the semiconductor element mounting portion is provided on an upper surface of the copper circuit board 3.

As a surface shape of the semiconductor element mounting portion, there can be cited a quadrangle shape such as a square shape and a rectangle shape, for example. In order to adjust the angle θ of the interior angle of the copper circuit board 3 to be 85° or more to 95° or less in the cross section, a method of carrying out press forming for the copper circuit board 3 is effective. In order to carry out press forming, the shape of the semiconductor element mounting portion is preferable to be a simple shape such as a quadrangle shape. When the surface shape of the semiconductor element mounting portion is the quadrangle shape, at least one edge may have a wave line shape or an S shape. Further, the surface shape of the semiconductor element mounting portion may be a circular shape, an oval shape, a polygon shape, or the like.

A thickness T of the copper circuit board 3 is preferable to be 0.7 mm or more. An upper limit of the thickness of the copper circuit board 3 is not limited in particular, but is preferable to be 7 mm or less, for example. When the thickness exceeds 7 mm, it becomes hard to adjust the angle θ of the interior angle of the copper circuit board 3 to be 85° or more to 95° or less in the cross section. The thickness T of the copper circuit board 3 is more preferable to be 1 mm or more to 7 mm or less, and further, to be 2 mm or more to 5 mm or less.

The bonding layer 4 bonds the ceramic substrate 2 and the copper circuit board 3. The bonding layer 4 contains Ag, Cu, and Ti. An Ag concentration of the bonding layer 4 is preferable to be 50 mass% or more to 80 mass% or less, a Cu concentration is preferable to be 20 mass% or more to 50 mass% or less, and a Ti concentration is preferable to be 1 mass% or more to 7 mass% or less. The bonding layer 4 is formed, for example, as a result that an active metal brazing material paste containing Ag, Cu, and Ti are applied and thereafter heated to be fixed to the ceramic substrate 2 and the copper circuit board 3.

As an active metal brazing material, it is possible to add either one or both of Sn and In at a ratio of 5 mass% or more to 25 mass% or less, other than Ag, Cu, and Ti. As a result that at least either one of Sn and In is added, a flexibility of the bonding layer 4 is improved and a TCT reliability can be improved. Further, since a bonding temperature is lowered, the TCT reliability can be improved. The bonding layer 4 may be a reaction layer of a metal component contained in the active metal brazing material and the copper circuit board 3, for example.

A thickness of the bonding layer 4 is preferable to be 20 µm or more to 200 µm or less. When the thickness of the bonding layer 4 is less than 20 µm, a not-bonded part of the ceramic substrate 2 and the copper circuit board 3 is liable to be formed. Further, when the thickness of the bonding layer 4 exceeds 200 µm, a characteristic such as a bonding strength is hard to be improved. Note that a thickness of a portion sandwiched by the ceramic substrate 2 and the copper circuit board 3 of the bonding layer 4 may be regarded as the thickness of the bonding layer 4. A boning strength (peel strength) of the copper circuit board 3 to the ceramic substrate 2 is preferable to be 10 kN/m or more.

The bonding layer 4 has a protruding portion which protrudes toward the outside of the copper circuit board 3. The protruding portion is provided in a manner to creep up along a side surface of the copper circuit board 3. In other words, a part of the copper circuit board 3 is embedded in the bonding layer 4 in a thickness direction. As shown in Fig. 1, a width of the protruding portion is referred to as a protruding amount W1 of the bonding layer 4. In the thickness direction of the copper circuit board 3, a length (depth of a portion embedded in the bonding layer 4 of the copper circuit board 3) of a portion contacting a side surface of the copper circuit board by creeping-up of the bonding layer 4 is referred to as a creeping-up amount W2 of the bonding layer 4. Values of the protruding amount W1 and the creeping-up amount W2 can be controlled by a composition of the active metal grazing material paste or a heat treatment condition at a bonding time, for example.

The protruding amount W1 is preferable to be 0.1 mm or more to 2 mm or less, for example. When the protruding amount W1 is less than 0.1 mm, relaxation of stress is liable to be insufficient. When the relaxation of stress is insufficient, the TCT reliability becomes liable to be reduced. When the protruding width W1 exceeds 2 mm, a characteristic such as a bonding strength is hard to be improved. Further, a space where the copper circuit board 3 is disposed on the ceramic substrate 2 becomes smaller, a size of the circuit substrate 1 is liable to be large. The protruding amount W1 is more preferable to be 0.1 mm or more to 1.0 mm or less, and further, to be 0.2 mm or more to be 0.7 mm or less.

The creeping-up amount W2 is preferable to be 0.05T (mm) or more to 0.6T (mm) or less in relation to the thickness T (mm) of the copper circuit board 3, for example. When the creeping-up amount W2 is less than 0.05T (mm), that is, less than 10% of the thickness T of the copper circuit board 3, relaxation of stress is liable to be insufficient. When the creeping-up amount W2 exceeds 0.6T (mm), a characteristic such as a bonding strength is hard to be improved. Further, the bonding layer 4 runs down and it becomes difficult to adjust the protruding amount W1 to be 2 mm or less. The creeping-up amount W2 is more preferable to be 0.1T (mm) or more to 0.4T (mm) or less.

By controlling the protruding amount W1 and the creeping-up amount W2 to be within the above-described range, stress is relaxed and the TCT reliability can be heightened even if a large-sized copper circuit board having a thickness T (mm) of 0.7 mm or more and a surface area of 25 mm² or more of a semiconductor element mounting portion is bonded to a ceramic substrate.

In the circuit substrate according to the embodiment, since the semiconductor element mounting portion can be provided in the end portion because of the copper circuit board having the interior angle of the angle θ of 85° or more to 95° or less in the cross section, increase of the area of the circuit substrate is suppressed, so that the circuit substrate can be made small-sized. Thus, a semiconductor device using the circuit substrate according to the embodiment has a high cooling effect, and a semiconductor element of high output can be mounted thereon. Further, a degree of freedom in design becomes high, a product can be made small-sized, and the TCT reliability can be improved.

Further, the copper circuit board 3 may have a diffusion region in which at least a part of components of the bonding layer 4 is diffused. The diffusion region contains at least Ti, and contains Ag, Cu, and Ti, for example. By forming the diffusion region, it is possible to improve a bonding strength of the copper circuit board 3 to the ceramic substrate 2, for example. Further, by adding at least either one of Sn and In to the bonding layer 4, a flexibility of the diffusion region is improved, so that the TCT reliability can be improved.

A thickness of the diffusion region is preferable to be 0.01 mm (10 µm) or more. For example, by making the thickness of the diffusion region be 10 µm or more, the bonding strength is improved, and it is possible to make the bonding strength (peel strength) of the copper circuit board 3 to the ceramic substrate 2 be 15 kN/m or more, for example. The thickness of the diffusion region is preferable to be 0.2 mm (200 µm) or less. When the thickness of the diffusion region exceeds 0.2 mm, a heating time period becomes long and too much stress is applied to the copper circuit board 3. The thickness of the diffusion region is more preferable to be 10 µm or more to 120 µm or less, and further, to be 20 µm or more to 100 µ or less.

In order to form the diffusion region within a desired range, it is preferable to control a heat processing condition at the time of bonding, for example. Further, in order to form the diffusion region within the desired range, it is preferable to make the thickness of the bonding layer 4 be 30 µm or more to 100 µm or less.

Fig. 2 is a diagram showing an example of the diffusion region. A circuit substrate 1 shown in Fig. 2 has a diffusion region 5, a diffusion region 6, and a diffusion region 7, in addition to a configuration shown in Fig. 1. The diffusion region 5 is a width direction diffusion region formed along a bonding surface (side surface of a cooper circuit board 3) to a bonding layer 4 in a width direction of the copper circuit board 3. The diffusion region 6 is a thickness direction diffusion region formed along a bonding surface (bottom surface of the copper circuit board 3) to the bonding layer 4 in a thickness direction of the copper circuit board 3. Note that a thickness of the diffusion region 6 is a length in a width direction of the copper circuit board 3. Further, the diffusion region 5 to the diffusion region 7 may be regarded as one continuous diffusion region.

The diffusion region 7 is provided in an end portion of the bonding surface to the bonding layer 4 in the width direction and the thickness direction of the copper circuit board 3. In other words, the diffusion region 7 is provided in an overlap portion of the diffusion region 5 and the diffusion region 6. A Ti concentration of the diffusion region 7 is higher than each Ti concentration of the diffusion region 5 and the diffusion region 6. Thus, the diffusion region 7 is also referred to as a Ti-rich region. By providing the diffusion region 7 being the Ti-rich region, it is possible to suppress heat expansion of the copper circuit board 3 end portion to which stress is liable to be applied.

The Ti concentration of the diffusion region 7 is higher than an average value of the Ti concentrations of the diffusion regions by 30% or more of the average value. Here, the average value of the Ti concentrations of the diffusion regions means an average value of values obtained by measuring respective Ti concentrations of the diffusion region 5 and the diffusion region 6. When the Ti concentration is lower than 30% of the average value, a difference from Ti concentration in the diffusion region 5 or from Ti concentration in the diffusion region 6 is small, and thus a sufficient heat expansion suppressing effect cannot be obtained. The Ti concentration of the diffusion region 7 is preferable to be higher than the average value of the Ti concentrations of the diffusion regions by 30% or more to 70% or less of the average value.

A linear expansion coefficient of each element at a room temperature (25°C) is 8.4 × 10⁻⁶/K in a case of Ti, 16.6 × 10⁻⁶/K in a case of Cu, and 19.0 × 10⁻⁶/K in a case of Ag. A linear expansion coefficient (25°C) of a ceramic substrate 2 is 6.7 × 10⁻⁶/K or more to 7.4 × 10⁻⁶/K or less in a case of an aluminum oxide substrate, 4.5 × 10⁻⁶/K or more to 5.5 × 10⁻⁶/K or less in a case of an aluminum nitride substrate, and 2.5 × 10⁻⁶/K or more to 3.5 × 10⁻⁶/K or less in a case of a silicon nitride substrate.

An area of the diffusion region 7 is preferable to be 400 µm² or more (= 20 µm × 20 µm), and further, 10000 µm² (= 100 µm × 100 µm) or more. An upper limit of the area of the diffusion region 7 is not limited in particular, but is preferable to be 500000 µm² or less. When a range of the diffusion region 7 is large, a heating time period is required to be made long. Therefore, there is an apprehension that unnecessary stress occurs in the copper circuit board 3.

Ranges of diffusion regions of Ag, Cu, and Ti in the diffusion region 5, the diffusion region 6, and the diffusion region 7 can be measured by an EPMA (Electron Probe Micro Analyzer), for example. By carrying out color mapping in plane analysis of Ag and Ti, for example, the range of the diffusion region in the copper circuit board can be investigated.

For example, in detection of the diffusion region 5, color mapping is carried out in a range of a width of 500 µm or more in the width direction of the copper circuit board 3. In detection of the diffusion region 6, color mapping is carried out in a range of a width of 500 µm or more in the thickness direction of the copper circuit board 3. In detection of the diffusion region 7, color mapping is carried out in a range of 500 µm × 500 µm or more in the width direction and the thickness direction of the copper circuit board 3. Further, an element concentration is measured by carrying out ICP (Inductively Coupled Plasma) mass spectrometry (ICP-MS) to each sample containing each of the diffusion region 5, the diffusion region 6, and the diffusion region 7, the sample being cut out from the copper circuit board 3.

When at least either one of Sn and In is added to the bonding layer 4, Sn and/or In are (is) diffused also to the diffusion region 5, the diffusion region 6, and the diffusion region 7. Therefore, similarly to in a case of Ag, Cu, Ti, by analyzing the cross section of the copper circuit board 3 by the EPMA, it is possible to analyze a diffusion state of Sn or In.

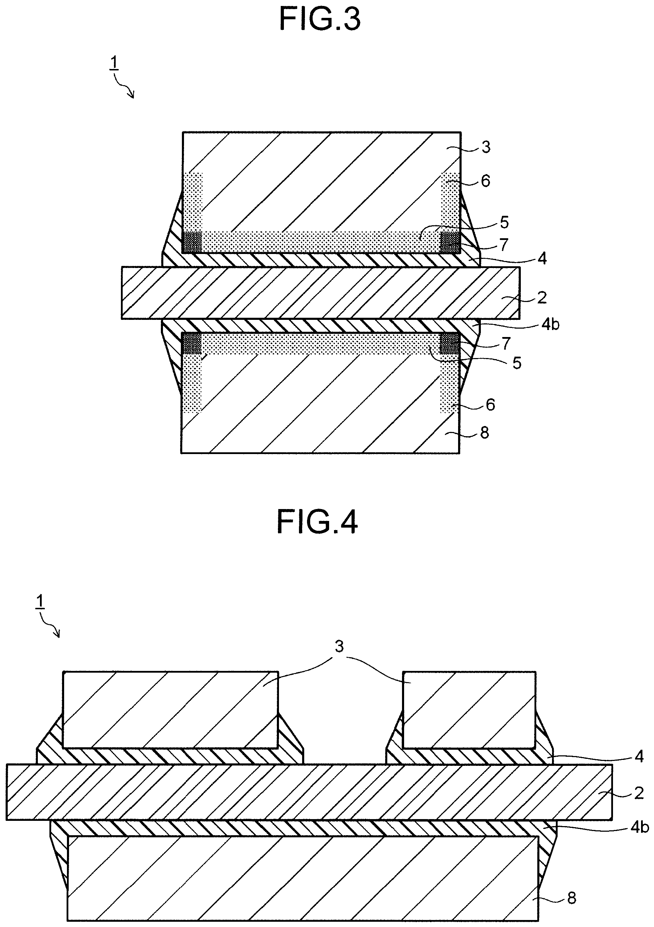

Fig. 3 is a diagram showing an example of the circuit substrate which has copper circuit boards on both sides of a ceramic substrate. A circuit substrate 1 shown in Fig. 3 has a ceramic substrate 2, a copper circuit board 3 (front copper circuit board) and a copper circuit board 8 (rear copper circuit board). In the circuit substrate 1 shown in Fig. 3, for components the same as those in the circuit substrates 1 shown in Fig. 1 and Fig. 2, explanation of the circuit substrates 1 shown in Fig. 1 and Fig. 2 can be cited properly.

The copper circuit board 8 is bonded to one surface (second surface) of the ceramic substrate 2 while sandwiching a bonding layer 4b. As the copper circuit board 8, a similar material to that of the copper circuit board 3 can be used. As the bonding layer 4b, which has a similar function to that of a bonding layer 4, a similar material can be used. A protruding amount W1 and a creeping-up amount W2 of the bonding layer 4b may have values similar to those of the bonding layer 4. For example, the protruding amount W1 of the bonding layer 4b is preferable to be 0.1 mm or more to 2 mm or less. The creeping-up amount W2 of the bonding layer 4b is preferable to be 0.05T (mm) or more to 0.6T (mm) or less. Further, similarly to the copper circuit board 3, the copper circuit board 8 may have a diffusion region 5, a diffusion region 6, and a diffusion region 7.

Fig. 4 is a diagram showing an example of a circuit substrate having a plurality of copper circuit boards on one side of a ceramic substrate. A circuit substrate 1 shown in Fig. 4 has a ceramic substrate 2, two copper circuit boards 3, and a copper circuit board 8. In the circuit substrate 1 shown in Fig. 4, for components the same as those in the circuit substrates 1 shown in Fig. 1 to Fig. 3, explanation of the circuit substrates 1 shown in Fig. 1 to Fig. 3 can be cited properly.

Each of the two copper circuit boards 3 is bonded to the ceramic substrate 2 while sandwiching a bonding layer 4. When the two copper circuit boards 3 are used as shown in Fig. 4, similarly to in the copper circuit boards 3 shown in Fig. 1 to Fig. 3, it is preferable that a thickness T of each copper circuit board 3 is 0.7 mm or more, that a protruding amount W1 is 0.1 mm or more to 2 mm or less, and that a creeping-up amount W2 is 0.05T (mm) or more to 0.6T (mm) or less. Further, though Fig. 4 illustrates the example in which two copper circuit boards 3 are disposed, three or more copper circuit boards 3 may be disposed. Note that the diffusion region 5 to the diffusion region 7 shown in Fig. 2 and Fig. 3 may be formed in the copper circuit boards 3 and the copper circuit board 8 which are shown in Fig. 4.

When the copper circuit board 8 is provided as in Fig. 3 and Fig. 4, a thickness of the copper circuit board 8 is preferable to be 0.7 mm or more, and further, to be 1 mm or more. Further, a volume of the copper circuit board 8 may be the same as a volume of the copper circuit board 3. The copper circuit board 8 has a function to prevent warpage of the circuit substrate 1. By bonding the copper circuit board 8 with the volume almost equal to the volume of the copper circuit substrate 3, warpage can be prevented. Further, as shown in Fig. 4, when the plurality of copper circuit boards 3 are disposed, it is preferable that a total volume of the circuit boards 3 and the volume of the copper circuit board 8 are made to be almost equal.

In the above-described circuit substrate, a TCT reliability can be heightened. Further, since the copper circuit board of the thickness of 0.7 mm or more is bonded to the ceramic substrate, it is possible to apply a large current/high voltage. Further, the TCT reliability can be heightened even if a semiconductor element having a high operating temperature such as a SiC element is mounted on the circuit substrate.

In the above-described circuit substrate, in 1000 cycles of TCTs, one cycle being -50°C × 30 minutes maintained → room temperature (25°C) × 10 minutes maintained → 175°C × 30 minutes maintained → room temperature (25°C) × 10 minutes maintained, for example, it is possible to prevent occurrence of peeling of the copper circuit board and of a crack of the ceramic substrate. Further, after 1000 cycles of the TCTs, it is possible to make a reduction rate of a bonding strength (peel strength) of the copper circuit board to the ceramic substrate be 10% or less. Further, by using a silicon nitride substrate having a three-point bending strength of 600 MPa or more, it is possible to make the reduction rate of the bonding strength (peel strength) be 10% or less even after 3000 cycles of TCTs, and further, 5000 cycles of TCTs.

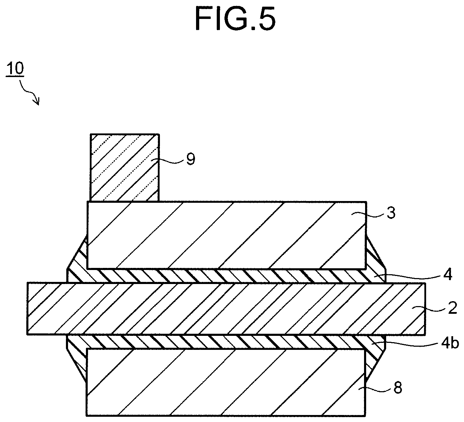

In a semiconductor device having the above-described circuit substrate, an excellent TCT reliability can be obtained. Fig. 5 is a diagram showing an example of the semiconductor device. A semiconductor device 10 shown in Fig. 5 has a ceramic substrate 2, a copper circuit board 3 provided on a first surface of the ceramic substrate 2, a bonding layer 4 bonding the first surface of the ceramic substrate and the copper circuit board 3, a copper circuit board 8 provided on a second surface of the ceramic substrate 2, a bonding layer 4b bonding the second surface of the ceramic substrate 2 and the copper circuit board 8, and a semiconductor element 9. A diffusion region 5 to a diffusion region 7 may be formed in each of the copper circuit board 3 and the copper circuit board 8. In the semiconductor device 10 shown in Fig. 5, for components the same as those in the circuit substrates 1 shown in Fig. 1 to Fig. 4, explanation of the circuit substrates 1 of respective drawings can be cited properly. Note that the diffusion regions 5 to the diffusion regions 7 shown in Fig. 2 and Fig. 3 may be formed in the copper circuit board 3 and the copper circuit board 8 which are shown in Fig. 5.

The semiconductor element 9 is bonded onto the copper circuit board 3 while sandwiching a bonding brazing material. Since the copper circuit board 3 has an interior angle of an angle θ of 85° or more to 95° or less in a cross section, a semiconductor element mounting portion can be provided in a manner to include a position of 0.1 mm or more to 2 mm or less from a copper circuit board 3 end portion. In other words, it is possible to mount the semiconductor element 9 at the position of 0.1 mm or more to 2 mm or less from the copper circuit board 3 end portion. Further, it is also possible to mount the semiconductor element 9 at a position of 0.1 mm or more to 1.0 mm or less from the copper circuit board 3 end portion.

Since the copper circuit board 3 has the interior angle of the angle θ of 85° or more to 95° or less in the cross section, it is easy to detect a position of the semiconductor element mounting portion by a CCD (Charge Coupled Device) camera or the like. Therefore, it becomes easier to use the above-described circuit substrate as a circuit substrate used for a semiconductor device.

Next, a manufacturing method for a circuit substrate will be described. The manufacturing method for the circuit substrate is not limited in particular as long as the above-described configuration of the circuit substrate can be satisfied, but as an efficient manufacturing method for a circuit substrate, a method below can be cited, for example.

First, a ceramic substrate 2 is prepared. As the ceramic substrate 2, a silicon nitride substrate, an aluminum nitride substrate, an aluminum oxide substrate, or the like can be used as described above.

Next, a brazing material paste for forming a bonding layer 4 is prepared. A brazing material is preferable to be an active metal brazing material. In the active metal brazing material, it is preferable that an Ag concentration is in a range of 50 mass% or more to 80 mass% or less, that a Cu concentration is in a range of 20 mass% or more to 50 mass% or less, and that a Ti concentration is in a range of 1 mass% or more to 7 mass% or less. To the active metal brazing material, it is possible to add either one or both of Sn and In at a ratio of 5 mass% or more to 25 mass% or less, other than Ag, Cu, and Ti. For example, by mixing respective metal powders and an organic solvent, the active metal brazing material paste can be prepared. Note that an average grain diameter of each metal powder is preferable to be 1 µm or more to 7 µm or less.

Next, the active metal brazing material paste is applied onto a ceramic substrate. A thickness of a coating layer of the active metal brazing material paste is preferable to be 10 µm or more to 50 µm or less. When the thickness of the coating layer is less than 10 µm, it becomes hard to form a diffusion region in a copper circuit board. Further, when the thickness of the coating layer exceeds 50 µm, a characteristic such as a bonding strength is hard to be improved, causing cost increase. The thickness of the coating layer is more preferable to be 20 µm or more to 40 µm or less.

Next, a copper circuit board is disposed on a part of the coating layer. When disposing the copper circuit board, it is preferable to dispose the copper circuit board by applying stress. As a result of disposing by applying stress to the circuit board, the applied brazing material paste slightly spreads. Thereby, a protruding portion of the bonding layer can be formed. Further, it is preferable to embed a part of the copper circuit board in a thickness direction in the coating layer. Thereby, it is possible to make it easier to form the protruding portion of the bonding layer in a manner to creep up along a side surface of the copper circuit board. Note that when disposing a copper circuit board without applying stress, an active metal brazing material paste may be added. Also in a case where a rear copper circuit board is provided or a case where a plurality of front copper circuit boards are provided, it is preferable to carry out a processing similar to the above.

As the copper circuit board, it is possible to use a copper circuit board having been processed to have a target size by a press work or a cutting process. By using the press work or the cutting process, it becomes easier to adjust an angle θ of an interior angle to be 85° or more to 95° or less in a cross section.

Next, heat bonding is carried out. In heat bonding, heating is carried out at 700°C or more to 900°C or less for 10 minutes or more to 150 minutes or less in a vacuum (1 × 10⁻² Pa or less) or in an inert atmosphere such as a nitrogen atmosphere. It is preferable to heat for 10 minutes or more in order to form a diffusion region. Further, it is preferable to heat for 30 minutes or more in order to form a Ti-rich region.

In a heat bonding step, it is also effective to carry out the heat bonding step in a nitrogen atmosphere (10 Pa or more) until a temperature reaches less than 500°C and in a vacuum (1 × 10⁻² Pa or less) after the temperature reaches 500°C or more. By carrying out a heat processing in the nitrogen atmosphere, it is possible to accelerate generation of TiN (titanium nitride) in the bonding layer. Further, by heating in the vacuum, it is possible to make it easier to let out a gas component generated by the active metal brazing material paste. As a result, a peel strength of the copper circuit board to the ceramic substrate becomes high.

In the heat bonding step, it is also effective to carry out heat bonding while switching heat bonding in the vacuum (1 × 10⁻² Pa or less) and heat bonding in the nitrogen atmosphere (10 Pa or more) alternately. By switching heat bonding in the vacuum and heat bonding in the nitrogen atmosphere alternately, it is possible to carry out generation of TiN (titanium nitride) and discharge of the gas component effectively.

Note that there is a case where the active metal brazing material paste creeps up a side surface of a copper circuit board at a time of heat bonding, changing a creeping-up amount W2 before and after heating. Thus, it is preferable to make the creeping-up amount W2 be 0.1T (mm) or more to 0.4T (mm) or less in a step of disposing the copper circuit bard onto the active metal brazing material paste.

The circuit substrate can be manufactured by the above-described steps. By controlling a composition of the active metal brazing material paste and a heat processing condition at a time of bonding as above, it is possible to control a protruding amount W1 and the creeping-up amount W2 of the bonding layer, a range of the diffusion region, and so on.

In the above-described manufacturing method of the circuit substrate, it is unnecessary to carry out etching for forming a copper circuit board having an end surface of a broad base shape. Therefore, cost increase can be suppressed. Further, in forming the above-described copper circuit board, also unnecessary is disposal of a ferric chloride solution or a cupric chloride solution, and of a hydrofluoric acid-based etching solution used in etching of TiN. Thus, it is possible to reduce an environmental load.

### [Example]

### (Examples 1 to 6, Comparative Examples 1 to 3)

First, a ceramic substrate is prepared. Table 1 shows kinds of ceramic substrates in respective examples 1 to 6 and comparative examples 1 to 3. Note that prepared as a silicon nitride substrate is a silicon nitride substrate of a heat conductivity of 90 W/m.K, of a three-point bending strength of 700 MPa, and of 50 mm in vertical dimension × 35 mm in horizontal direction × 0.32 mm in thickness dimension. Prepared as an aluminum nitride substrate is an aluminum nitride substrate of a heat conductivity of 190 W/m.K, of a three-point bending strength of 360 MPa, and of 50 mm in vertical dimension × 35 mm in horizontal dimension × 0.635 mm in thickness dimension. Prepared as an aluminum oxide substrate is an aluminum oxide substrate of a heat conductivity of 20 W/m.K, of a three-point bending strength of 500 MPa, and of 50 mm in vertical dimension × 35 mm in horizontal dimension × 1.0 mm in thickness dimension.

Next, 65 mass% of Ag powder, 30 mass% of Cu powder, 5 mass% of Ti powder, and an organic solvent are mixed to prepare an active metal brazing material paste in which a total of Ag, Cu, and Ti is 100 mas%. Note that an average grain diameter of each of Au powder, Cu powder, and Ti powder is 2 µm.

Next, a copper circuit board is prepared. Table 1 shows dimensions (vertical dimension (mm) × horizontal dimension (mm) × thickness dimension (mm)) and angles θ of interior angles of cross sections of the copper circuit boards in the respective examples 1 to 6 and comparative examples 1 to 3. Note that the copper circuit board has been processed to have a target size by a press work or a cutting process.

Next, the active metal brazing material paste is applied onto a first surface of the ceramic substrate, and the copper circuit board to be a front copper circuit board is disposed on a part of a coating layer of the active metal brazing material paste. On that occasion, stress is applied to the front copper circuit board so that a part of the copper circuit board may be disposed in a manner to be embedded in the active metal brazing material paste in a thickness direction. Similarly, the active metal brazing material paste is applied onto a second surface of the ceramic substrate and the copper circuit board to be a rear copper circuit board is disposed on a part of a coating layer of the active metal brazing material paste.

Next, by carrying out heat bonding under a condition of in a vacuum (1 × 10⁻³ Pa), at 800°C or more to 850°C or less, and for 70 minutes or more to 90 minutes or less, circuit substrates according to the examples 1 to 6 and the comparative examples 1 to 3 are fabricated. Table 1 shows thicknesses of the bonding layers, protruding amounts W1, and creeping-up amounts W2 in the examples 1 to 6 and the comparative examples 1 to 3. Note that in the comparative example 1, W1 = 0T and W2 = 0T. In the comparative example 2, the copper circuit board is disposed without stress being applied, and W2 = 0T. In the comparative example 3, the copper circuit board is disposed with stress being applied, and W2 = 0.8T.

**[Table 1]**

| | Kind of Ceramic Substrate (Thickness (mm)) | Copper Circuit Board | | Bonding Layer Thickness (µm) | W1 (mm) | W2 (mm) |
|---|---|---|---|---|---|---|
| | | Vertical Dimension (mm) × Horizontal Dimension (mm) × Thickness Dimension (mm) | θ | | | |
| Example 1 | Silicon Nitride Substrate (0.32) | 30×10×2 | 91° | 50 | 0.6 | 0.05T (=0.1) |
| Example 2 | Silicon Nitride Substrate (0.32) | 35×30×3 | 90° | 100 | 1.0 | 0.3T (=0.9) |
| Example 3 | Silicon Nitride Substrate (0.32) | 35×30×5 | 90° | 200 | 0.4 | 0.02T (=0.3) |
| Example 4 | Aluminum Nitride Substrate (0.635) | 30×20×0.7 | 89° | 50 | 0.2 | 0.2T (=0.3) |
| Example 5 | Aluminum Oxide Substrate (1.0) | 30×30×0.8 | 90° | 50 | 0.8 | 0.6 (=1.2) |
| Example 6 | Silicon Nitride Substrate (0.32) | 35×30×0.8 | 90° | 30 | 0.3 | 0.1T (=0.08) |
| Comparative Example 1 | Silicon Nitride Substrate (0.32) | 30×30×2 | 90° | 50 | 0.0 | 0T (=0) |
| Comparative Example 2 | Silicon Nitride Substrate (0.32) | 30×30×2 | 90° | 50 | 1.0 | 0T (=0) |
| Comparative Example 3 | Silicon Nitride Substrate (0.32) | 30×30×2 | 90° | 400 | 1.0 | 0.8T (=1.6) |

In the circuit substrates according to the examples 1 to 6 and the comparative examples 1 to 3, thicknesses of diffusions region in width directions, thicknesses of diffusion regions in thickness directions, and areas of Ti-rich regions are calculated by measuring diffusion states of Ti of cross sections by an EPMA. Table 2 shows results.

**[Table 2]**

| | Diffusion Region | | |
|---|---|---|---|
| | Thickness of Diffusion Region in Width Direction (mm) | Thickness of Diffusion Region in Thickness Direction (mm) | Area of Ti-Rich Region (µm²) |
| Example 1 | 0.15 | 0.11 | 12500 |
| Example 2 | 0.14 | 0.12 | 25000 |
| Example 3 | 0.16 | 0.14 | 28400 |
| Example 4 | 0.15 | 0.10 | 11200 |
| Example 5 | 0.14 | 0.12 | 13000 |
| Example 6 | 0.12 | 0.10 | 11700 |
| Comparative Example 1 | 0.08 | 0 | 0 |
| Comparative Example 2 | 0.06 | 0 | 0 |
| Comparative Example 3 | 0.12 | 0.20 | 25000 |

### (Examples 7 to 10)

First, as a ceramic substrate, there is prepared a silicon nitride substrate of 50 mm in vertical dimension × 35 mm in horizontal dimension × 0.32 mm in thickness dimension. Table 3 shows heat conductivities and three-point bending strengths of the silicon nitride substrates of the examples 7 to 10.

**[Table 3]**

| | Heat Conductivity (W/m.K) | Three-Point Bending Strength (MPa) |
|---|---|---|
| Example 7 | 85 | 730 |
| Example 8 | 90 | 600 |
| Example 9 | 95 | 650 |
| Example 10 | 60 | 500 |

Next, 60 mass% of Ag powder, 26 mass% of Cu powder, 10 mass% of Sn powder, 4 mass% of Ti powder, and an organic solvent are mixed, to prepare an active metal brazing material paste in which a total of Ag, Cu, Sn, and Ti is 100 mass%. Note that an average grain diameter of each of the Ag powder, the Cu powder, the Sn powder, and the Ti powder is 2 µm.

Next, a copper circuit board is prepared. Table 4 shows dimensions (vertical dimension (mm) × horizontal dimension (mm) × thickness dimension (mm)) and angles θ of interior angles of cross sections of the copper circuit boards of the examples 7 to 10. Note that the copper circuit board has been processed to have a target size by a press work or a cutting process.

Next, the active metal brazing material paste is applied onto a first surface of the ceramic substrate, and the copper circuit board to be a front copper circuit board is disposed on a part of a coating layer of the active metal brazing material paste. On that occasion, stress is applied to the front copper circuit board so that the front copper circuit board may be disposed in a manner that a part of the front copper circuit board is embedded in the active metal brazing material paste. Similarly, the active metal brazing material paste is applied onto a second surface of the ceramic substrate and the copper circuit board to be a rear copper circuit board is disposed on a part of a coating layer of the active metal brazing material paste.

Next, by carrying out heat bonding steps under conditions shown in Table 4, circuit substrates according to the examples 7 to 10 are fabricated. Table 4 shows thicknesses of bonding layers, protruding amounts W1, and creeping-up amounts W2 in the examples 7 to 10.

**[Table 4]**

| | Condition of Heat Bonding Step | Copper Circuit Board | | Bonding Layer Thickness (µm) | W1 (mm) | W2 (mm) |
|---|---|---|---|---|---|---|
| | | Vertical Dimension (mm) × Horizontal Dimension (mm) × Thickness Dimension (mm) | θ | | | |
| Example 7 | 820°C (Nitrogen Atmosphere (10 Pa Or More) When Less Than 500°C, In Vacuum (10⁻² Pa Or Less) When 500°C Or More) × 30 Minutes | 20×10×2 | 90° | 80 | 0.3 | 0.1T (=0.2) |
| Example 8 | 830°C (Nitrogen Atmosphere (10 Pa Or More) When Less Than 500°C, In Vacuum (10⁻³ Pa Or Less) When 500°C Or More) × 30 Minutes | 35×30×3 | 90° | 120 | 0.5 | 0.5T (=1.5) |
| Example 9 | 820°C (Nitrogen Atmosphere (10 Pa Or More) When Less Than 500°C, In Vacuum (10⁻³ Pa Or Less) When 500°C Or More) × 30 Minutes | 35×30×1.5 | 90° | 100 | 0.4 | 0.2T (=0.3) |
| Example 10 | 800°C (In Vacuum (10⁻³ Pa)) × 10 Minutes | 30×20×1 | 90° | 40 | 0.2 | 0.2T(=0.2) |

Next, in the circuit substrates according to the examples 7 to 10, thicknesses of diffusion regions in width directions and thicknesses of diffusion regions in thickness directions, and areas of Ti-rich regions are calculated by measuring diffusion states Ti of cross sections by the EPMA. Table 5 shows results.

**[Table 5]**

| | Diffusion Region | | |
|---|---|---|---|
| | Thickness of Diffusion Region in Width Direction (mm) | Thickness of Diffusion Region in Thickness Direction (mm) | Area of Ti-Rich Region (µm²) |
| Example 7 | 0.03 | 0.05 | 1500 |
| Example 8 | 0.07 | 0.10 | 6700 |
| Example 9 | 0.05 | 0.06 | 2800 |
| Example 10 | 0.02 | 0.02 | 400 |

In the examples 7 to 9, heat bonding is carried out while a nitrogen atmosphere and a vacuum atmosphere are combined, and TiN (titanium nitride) is generated largely in silicon nitride substrate sides of bonding layers, the diffusion areas being small. On the other hand, in the example 10, since a heat processing time period is short, the area of the Ti-rich region is small. Based on the above, it is proved that it is possible to control a range of the diffusion region such as a Ti-rich region by the heat processing condition.

Bonding strengths of the copper circuit boards and TCT reliabilities are evaluated for the circuit substrates according to the examples and the comparative examples. As the bonding strength of the copper circuit board, a peel strength of the copper circuit board to the ceramic substrate is found. Further, TCTs are repeated 1000 cycles, one cycle being -40°C × 30 minutes maintained → room temperature (25°C) × 10 minutes maintained → 175°C × 30 minutes maintained → room temperature (25°C) × 10 minutes maintained. After the TCTs, by checking presence/absence of a defect such as peeling of the copper circuit board and occurrence of a crack of the ceramic substrate, the TCT reliability is evaluated. Further, for the circuit substrate in which the defect does not occur, the peel strength of the copper circuit board to the ceramic substrate is measured, and a reduction rate from the peel strength before the TCT is calculated. Table 6 shows results.

**[Table 6]**

| | PEEL STRENGTH (kN/m) | AFTER TCT | | |
|---|---|---|---|---|
| | | DEFECT | PEEL STRENGTH (kN/m) | REDUCTION RATE OF PEEL STRENGTH (%) |
| Example 1 | 23.1 | ABSENT | 22.8 | 1.3 |
| Example 2 | 24.0 | ABSENT | 23.4 | 2.5 |
| Example 3 | 21.6 | ABSENT | 21.5 | 0.5 |
| Example 4 | 17.7 | ABSENT | 16.5 | 6.8 |
| Example 5 | 18.5 | ABSENT | 16.9 | 8.4 |
| Example 6 | 18.9 | ABSENT | 18.7 | 1.0 |
| Example 7 | 20.0 | ABSENT | 19.8 | 1.0 |
| Example 8 | 21.4 | ABSENT | 21.3 | 0.4 |
| Example 9 | 20.3 | ABSENT | 20.2 | 0.5 |
| Example 10 | 13.5 | ABSENT | 13.3 | 1.4 |
| Comparative Example 1 | 10.0 | PRESENT | - | - |
| Comparative Example 2 | 8.0 | PRESENT | - | - |
| Comparative Example 3 | 18.0 | ABSENT | 16.5 | 8.3 |

As is known from Table 6, in the circuit substrates according to the examples 1 to 10, the peel strengths are high or the reduction rates of the peel strengths are low. Thus, it is known that a TCT characteristic can be heightened even in a circuit substrate made by bonding a copper circuit board having a thickness of 0.7 mm or more, further, of 1 mm or more to a ceramic substrate.

For the circuit substrates according to the examples 1 to 10, TCTs are repeated 3000 cycles and 5000 cycles, one cycle being -40°C × 30 minutes maintained → room temperature (25°C) × 10 minutes maintained → 175°C × 30 minutes maintained → room temperature (25°C) × 10 minutes maintained. After 3000 cycles or 5000 cycles of TCTs, there is checked presence/absence of a defect such as peeling of the copper circuit board and occurrence of a crack of the ceramic substrate. A peel strength of the copper circuit board to the ceramic substrate after 5000 cycles of the TCTs is measured. Table 7 shows results.

**[Table 7]**

| | TCT | | |
|---|---|---|---|
| | DEFECT AFTER 3000 CYCLES | DEFECT AFTER 5000 CYCLES | PEEL STRENGTH AFTER 5000 CYCLES (kN/m) |
| Example 1 | ABSENT | ABSENT | 21.8 |
| Example 2 | ABSENT | ABSENT | 23.0 |
| Example 3 | ABSENT | ABSENT | 20.3 |
| Example 4 | PRESENT | PRESENT | - |
| Example 5 | PRESENT | PRESENT | - |
| Example 6 | ABSENT | ABSENT | 18.0 |
| Example 7 | ABSENT | ABSENT | 19.5 |
| Example 8 | ABSENT | ABSENT | 19.8 |
| Example 9 | ABSENT | ABSENT | 19.6 |
| Example 10 | ABSENT | PRESENT | 12.9 |

As shown in Table 7, the silicon nitride circuit substrates according to the examples 1 to 3 and the examples 6 to 10 using silicon nitride substrates having three-point bending strengths of 600 MPa or more exhibit excellent TCT characteristics. Bonding strengths of the silicon nitride substrates according to the examples 7 to 9 in which Sn is added to active metal brazing materials are high, the peel strengths of the copper circuit boards to the silicon nitride substrates after 5000 cycles of TCTs are high, and the reduction rates of the peel strengths are low.

In order to mount semiconductor elements on the copper circuit boards of the circuit substrates according to examples 1 to 10, position detection is carried out by a CCD camera, and detectable shortest positions from copper circuit board end portions are measured. Further, as a comparative example 4, a copper circuit board in which an angle θ of an interior angle of a cross section is 80° is prepared, and a detectable shortest position from a copper circuit board end portion is similarly measured. Table 8 shows results.

**[Table 8]**

| | Shortest Detected Position From Copper Board End Portion (mm) |
|---|---|
| Example 1 | 0.1 |
| Example 2 | 0.1 |
| Example 3 | 0.1 |
| Example 4 | 0.1 |
| Example 5 | 0.1 |
| Example 6 | 0.1 |
| Example 7 | 0.1 |
| Example 8 | 0.1 |
| Example 9 | 0.1 |
| Example 10 | 0.1 |
| Comparative Example 4 | 1.2 |

As is known from Table 8, in the circuit substrates according to the examples 1 to 10, the detectable shortest positions from the copper circuit board end portions are 0.1 mm. As described above, in the circuit substrates according to the examples 1 to 10. it is possible to detect positions of 0.1 mm from the end portions by a CCD camera or the like. Thus, in the circuit substrates according to the examples 1 to 10, it is possible to use regions including positions of 0.1 mm from the end portions of the copper circuit boards as semiconductor element mounting portions. In contrast, in a case where the angle θ of the interior angle of the cross section is 80° as in the copper circuit board according to the comparative example 4, a position 1.2 mm or more apart from the end portion of the copper circuit board can be barely detected.

## Claims

1. A circuit substrate (1) comprising:
a ceramic substrate (2) having a first surface and a second surface facing the first surface;
a copper circuit board (3, 8) provided on at least one of the first and second surfaces and including a thickness T (mm) of 0.7 mm or more, an interior angle having angle θ of 85° or more to 95° or less in a cross section, and a semiconductor element mounting portion of 25 mm² or more provided in a surface of the copper circuit board (3, 8); and
a bonding layer (4, 4b) containing Ag, Cu and Ti, and bonding the ceramic substrate (2) and the copper circuit board (3, 8),
the bonding layer (4, 4b) having a protruding portion, the protruding portion protruding outside the copper circuit board (3, 8), creeping up along a side surface of the copper circuit board (3, 8), and having a protruding amount W1 of 0.1 mm or more to 1.0 mm or less and a creeping-up amount W2 of 0.05T (mm) or more to 0.6T (mm) or less.

2. The circuit substrate (1) according to claim 1,
wherein the ceramic substrate (2) is a silicon nitride substrate having a thickness of 0.1 mm or more to 1.0 mm or less.

3. The circuit substrate (1) according to claim 1,
wherein the copper circuit board (3, 8) has the thickness T (mm) of 1 mm or more.

4. The circuit substrate (1) according to claim 1,
wherein the copper circuit board (3, 8) has the interior angle of the angle θ of 89° or more to 91° or less in the cross section.

5. The circuit substrate (1) according to claim 1,
wherein the copper circuit board (3, 8) has the thickness T (mm) of 7 mm or less.

6. The circuit substrate (1) according to claim 1,
wherein the copper circuit board (3, 8) has the semiconductor element mounting portion of 100 mm² or more.

7. The circuit substrate (1) according to claim 1,
wherein the bonding layer (4, 4b) contains at least one of Sn and In.

8. The circuit substrate (1) according to claim 1,
wherein the copper circuit board (3, 8) has a diffusion region (5, 6, 7) provided along a bonding surface to the bonding layer (4, 4b), containing Ti, and having a thickness of 0.01 mm or more, and
wherein the diffusion region (5, 6, 7) has:
a first diffusion region (5) provided along the bonding surface to the bonding layer in a width direction of the copper circuit board (3, 8),
a second diffusion region (6) provided along the bonding surface to the bonding layer in a thickness direction of the copper circuit board (3, 8), and
a third diffusion region (7) provided in an overlap portion of the first and second diffusion regions (5, 6) and containing Ti of a concentration higher than an average value of Ti concentrations of the first and second diffusion regions (5, 6) by 30% or more of the average value.

9. The circuit substrate (1) according to claim 8,
wherein an area of the third diffusion region (7) is 400 µm² or more.

10. The circuit substrate (1) according to claim 1,
wherein the semiconductor element mounting portion is provided in a manner to include a position of 0.1 mm or more to 2 mm or less from an end portion of the copper circuit board (3, 8).

11. The circuit substrate (1) according to claim 1, comprising:
a first copper circuit board (3) and a second copper circuit board (8), as the copper circuit board (3, 8); and
a first bonding layer (4) bonding the first surface of the ceramic substrate (2) and the first copper circuit board (3) and a second bonding layer (4b) bonding the second surface of the ceramic substrate (2) and the second copper circuit board (8), as the bonding layer (4, 4b).

12. A semiconductor device (10) comprising:
the circuit substrate (1) according to claim 1; and
a semiconductor element (9) mounted on the semiconductor element mounting portion.

## Patentansprüche

1. Ein Schaltungssubstrat (1), aufweisend:
ein Keramiksubstrat (2) mit einer ersten Oberfläche und einer zweiten Oberfläche, die der ersten Oberfläche zugewandt ist;
eine Kupferleiterplatte (3, 8), die auf mindestens einer der ersten und zweiten Oberfläche vorgesehen ist und eine Dicke T (mm) von 0,7 mm oder mehr, einen Innenwinkel mit einem Winkel θ von 85° oder mehr bis 95° oder weniger in einem Querschnitt und einen Halbleiterelement-Befestigungsabschnitt von 25 mm² oder mehr umfasst, der in einer Oberfläche der Kupferleiterplatte (3, 8) vorgesehen ist; und
eine Verbindungsschicht (4, 4b), die Ag, Cu und Ti enthält und das Keramiksubstrat (2) und die Kupferleiterplatte (3, 8) verbindet,
wobei die Verbindungsschicht (4, 4b) einen hervorstehenden Abschnitt aufweist, wobei der hervorstehende Abschnitt aus der Kupferleiterplatte (3, 8) hervorsteht, entlang einer Seitenfläche der Kupferleiterplatte (3, 8) nach oben kriecht und einen hervorstehenden Betrag W1 von 0,1 mm oder mehr bis 1,0 mm oder weniger und einen nach oben kriechenden Betrag W2 von 0,05T (mm) oder mehr bis 0,6T (mm) oder weniger aufweist.

2. Das Schaltungssubstrat (1) nach Anspruch 1,
wobei das Keramiksubstrat (2) ein Siliziumnitridsubstrat mit einer Dicke von 0,1 mm oder mehr bis 1,0 mm oder weniger ist.

3. Das Schaltungssubstrat (1) nach Anspruch 1,
wobei die Kupferleiterplatte (3, 8) die Dicke T (mm) von 1 mm oder mehr aufweist.

4. Das Schaltungssubstrat (1) nach Anspruch 1,
wobei die Kupferleiterplatte (3, 8) im Querschnitt den Innenwinkel des Winkels θ von 89° oder mehr bis 91° oder weniger aufweist.

5. Das Schaltungssubstrat (1) nach Anspruch 1,
wobei die Kupferleiterplatte (3, 8) die Dicke T (mm) von 7 mm oder weniger aufweist.

6. Das Schaltungssubstrat (1) nach Anspruch 1,
wobei die Kupferleiterplatte (3, 8) den Halbleiterelement-Befestigungsabschnitt von 100 mm² oder mehr aufweist.

7. Das Schaltungssubstrat (1) nach Anspruch 1,
wobei die Verbindungsschicht (4, 4b) mindestens eines von Sn und In enthält.

8. Das Schaltungssubstrat (1) nach Anspruch 1,
wobei die Kupferleiterplatte (3, 8) einen Diffusionsbereich (5, 6, 7) aufweist, der entlang einer Verbindungsoberfläche zu der Verbindungsschicht (4, 4b) vorgesehen ist, Ti enthält und eine Dicke von 0,01 mm oder mehr aufweist, und
wobei der Diffusionsbereich (5, 6, 7) folgendes aufweist:
einen ersten Diffusionsbereich (5), der entlang der Verbindungsfläche zu der Verbindungsschicht in einer Breitenrichtung der Kupferleiterplatte (3, 8) vorgesehen ist,
einen zweiten Diffusionsbereich (6), der entlang der Verbindungsfläche zu der Verbindungsschicht in einer Dickenrichtung der Kupferleiterplatte (3, 8) vorgesehen ist, und
einen dritten Diffusionsbereich (7), der in einem Überlappungsabschnitt des ersten und des zweiten Diffusionsbereichs (5, 6) vorgesehen ist und Ti mit einer Konzentration enthält, die um 30% oder mehr des Mittelwerts der Ti-Konzentrationen des ersten und des zweiten Diffusionsbereichs (5, 6) höher ist als der Mittelwert der Ti-Konzentrationen des ersten und des zweiten Diffusionsbereichs (5, 6).

9. Das Schaltungssubstrat (1) nach Anspruch 8,
wobei eine Fläche des dritten Diffusionsbereichs (7) 400 µm² oder mehr beträgt.

10. Das Schaltungssubstrat (1) nach Anspruch 1,
wobei der Halbleiterelement-Befestigungsabschnitt in einer Weise vorgesehen ist, dass er eine Position von 0,1 mm oder mehr bis 2 mm oder weniger von einem Endabschnitt der Kupferleiterplatte (3, 8) umfasst.

11. Das Schaltungssubstrat (1) nach Anspruch 1, aufweisend:
eine erste Kupferleiterplatte (3) und eine zweite Kupferleiterplatte (8) als die Kupferleiterplatte (3, 8); und
eine erste Verbindungsschicht (4), die die erste Oberfläche des Keramiksubstrats (2) und die erste Kupferleiterplatte (3) verbindet, und eine zweite Verbindungsschicht (4b), die die zweite Oberfläche des Keramiksubstrats (2) und die zweite Kupferleiterplatte (8) verbindet, als die Verbindungsschicht (4, 4b).

12. Eine Halbleitervorrichtung (10), aufweisend:
das Schaltungssubstrat (1) nach Anspruch 1; und
ein Halbleiterelement (9), das auf dem Halbleiterelement-Befestigungsabschnitt befestigt ist.

## Revendications

1. Substrat de circuit (1) comprenant :
un substrat céramique (2) ayant une première surface et une seconde surface faisant face à la première surface ;
une plaque de circuit en cuivre (3, 8) fournie sur au moins une des première et seconde surfaces et incluant une épaisseur T (mm) de 0,7 mm ou supérieure, un angle intérieur ayant un angle θ de 85° ou supérieur à 95° ou inférieur dans une section transversale, et une portion de montage d'élément de semiconducteur de 25 mm² ou supérieure fournie dans une surface de la plaque de circuit en cuivre (3, 8) ; et
une couche de liaison (4, 4b) contenant Ag, Cu et Ti, et liant le substrat céramique (2) et la plaque de circuit en cuivre (3, 8),
la couche de liaison (4, 4b) ayant une portion en saillie, la portion en saillie faisant saillie vers l'extérieur de la plaque de circuit en cuivre (3, 8), en augmentant le long d'une surface latérale de la plaque de circuit en cuivre (3, 8), et ayant une quantité de saillie W1 de 0,1 mm ou supérieure à 1,0 mm ou inférieure et une quantité d'augmentation W2 de 0,05T (mm) ou supérieur à 0,6T (mm) ou inférieure.

2. Substrat de circuit (1) selon la revendication 1,
dans lequel le substrat céramique (2) est un substrat en nitrure de silicium ayant une épaisseur de 0,1 mm ou supérieure à 1,0 mm ou inférieure.

3. Substrat de circuit (1) selon la revendication 1,
dans lequel la plaque de circuit en cuivre (3, 8) présente l'épaisseur T (mm) de 1 mm ou supérieure.

4. Substrat de circuit (1) selon la revendication 1,
dans lequel la plaque de circuit en cuivre (3, 8) présente l'angle intérieur de l'angle θ de 89° ou supérieur à 91° ou inférieur dans la section transversale.

5. Substrat de circuit (1) selon la revendication 1,
dans lequel la plaque de circuit en cuivre (3, 8) présente l'épaisseur T (mm) de 7 mm ou inférieure.

6. Substrat de circuit (1) selon la revendication 1,
dans lequel la plaque de circuit en cuivre (3, 8) présente la portion de montage d'élément de semiconducteur de 100 mm² ou supérieure.

7. Substrat de circuit (1) selon la revendication 1,
dans lequel la couche de liaison (4, 4b) contient au moins un de Sn et In.

8. Substrat de circuit (1) selon la revendication 1,
dans lequel la plaque de circuit en cuivre (3, 8) présente une région de diffusion (5, 6, 7) fournie le long d'une surface de liaison à la couche de liaison (4, 4b), contenant Ti, et ayant une épaisseur de 0,01 mm ou supérieure, et
dans lequel la région de diffusion (5, 6, 7) présente :
une première région de diffusion (5) fournie le long de la surface de liaison à la couche de liaison dans une direction de largeur de la plaque de circuit en cuivre (3, 8),
une seconde région de diffusion (6) fournie le long de la surface de liaison à la couche de liaison dans une direction d'épaisseur de la plaque de circuit en cuivre (3, 8), et
une troisième région de diffusion (7) fournie dans une portion de chevauchement des première et seconde régions de diffusion (5, 6) et contenant Ti dans une concentration supérieure à une valeur moyenne de concentrations de Ti des première et seconde régions de diffusion (5, 6) de 30 % ou supérieure de la valeur moyenne.

9. Substrat de circuit (1) selon la revendication 8,
dans lequel une surface de la troisième région de diffusion (7) est de 400 µm² ou supérieure.

10. Substrat de circuit (1) selon la revendication 1,
dans lequel la portion de montage d'élément de semiconducteur est fournie de manière à inclure une position de 0,1 mm ou supérieure à 2 mm ou inférieure à partir d'une portion d'extrémité de la plaque de circuit en cuivre (3, 8).

11. Substrat de circuit (1) selon la revendication 1, comprenant :
une première plaque de circuit en cuivre (3) et une seconde plaque de circuit en cuivre (8), comme la plaque de circuit en cuivre (3, 8) ; et
une première couche de liaison (4) liant la première surface du substrat céramique (2) et la première plaque de circuit en cuivre (3) et une seconde couche de liaison (4b) liant la seconde surface du substrat céramique (2) et la seconde plaque de circuit en cuivre (8), comme la couche de liaison (4, 4b).

12. Dispositif de semiconducteur (10) comprenant :
le substrat de circuit (1) selon la revendication 1 ; et
un élément de semiconducteur (9) monté sur la portion de montage d'élément de semiconducteur.
